# EUROPÄISCHE PATENTANMELDUNG

(11) **EP 2 061 073 A2**
(43) Veröffentlichungstag der Anmeldung: **20.05.2009**
(21) Anmeldenummer: 08019823.7
(22) Anmeldetag: 13.11.2008
(51) Int. Cl.: H01L 21/67

(54) **Vorrichtung und Verfahren zum Transport von empfindlichem Gut**

(30) Priorität: 13.11.2007 DE 102007054092
(71) Anmelder: Rena Sondermaschinen GmbH, 78148 Gütenbach (DE)
(72) Erfinder: Hübel, Egon, 90537 Feucht (DE)
(74) Vertreter: Stürken, Joachim

(57) **Zusammenfassung**

Die Erfindung betrifft die Förderung von flachem Gut 1 in nasschemischen und/oder elektrolytischen Durchlaufanlagen mit rotierenden Wellen und darauf angeordneten Fördermitteln 10 als Transporträder 11 und/oder Kontakträdern 17.

Zur Vermeidung von Beschädigungen der Oberfläche des Gutes 1 und/oder zur Vermeidung von Bruch des Gutes werden die das Gut berührenden Fördermittel 10 individuell radial beweglich von den Transportwellen aufgenommen und beweglich gelagert. Die Wellen bestehen aus mindestens zwei Stäben 3. Sie nehmen radial verschiebbar die mit entsprechend größeren kongruenten Öffnungen 12 versehenen Fördermittel 10 auf.

Die Fördermittel können auch von je einem Federelement 18, das sich bevorzugt im Zentrum der Transportwellen befindet, gehalten werden, wodurch die Auflagekraft auf das Gut 1 vergrößert oder verkleinert werden kann. Zur elektrolytischen Behandlung kann über das Federelement 18 der Behandlungsstrom zum rotierenden Kontaktrad 17 geleitet werden.

## Beschreibung

Die Erfindung betrifft die Förderung von flachem Gut zur nasschemischen oder elektrolytischen Behandlung, bevorzugt in horizontaler Ausrichtung, in so genannten Durchlaufanlagen mittels rotierender Fördermittel auf Transportwellen und/oder Transportwalzen. Die Behandlung kann mit Gas oder mit Flüssigkeiten erfolgen. Bei dem Gut handelt es sich z.B. um Substrate als Leiterplatten, Leiterfolien, Wafer, Solarzellen, Hybride und dergleichen. Das flache Gut ist gegen mechanische Beschädigungen an einer oder an seinen beiden Oberflächen meist sehr empfindlich. Dies verlangt u. a. ein sanftes Abrollen der rotierenden Fördermittel auf den Oberflächen. Insbesondere ist hierbei die Auflage- oder Andruckkraft der Fördermittel auf die Oberflächen von großem Einfluss. Kleine, in einer Durchlaufanlage zu produzierende Abschnitte als Gut bzw. Güter, wie z.B. Wafer, Hybride oder Solarzellen aus Silizium werden auch nebeneinander, d.h. parallel durch die Durchlaufanlage gefördert. Dafür befinden sich auf einer Transportwelle quer zur Förderrichtung für jede Förderspur Fördermittel als Transporträder, die nur zum Transport des Gutes dienen und/oder als Kontakträder, die sowohl zum Transport des Gutes als auch zur elektrischen Kontaktierung desselben dienen.

Die Transportwellen und alle weiteren Bauelemente des Fördersystems sind mit Herstellungstoleranzen behaftet. Die Transportwellen lassen sich präzise, d.h. unter anderem schlagfrei nur sehr aufwändig herstellen und in diesem Idealzustand während des praktischen rauen Betriebes kaum halten. Der Regelfall weicht von diesem Idealzustand ab. Dies hat zur Folge, dass die Kräfte quer zur Förderrichtung, die auf jedes einzelne Gut wirken, unterschiedlich groß sind. Insgesamt wird dadurch auch der spurgenaue Transport des Gutes unsicher. Beschädigungen bis hin zum Bruch eines empfindlichen Gutes sind die Folge. Besonders die bruchempfindlichen Wafer und Solarzellen, bestehend aus Silizium, sind in derartigen Durchlaufanlagen sehr gefährdet.

Prozesse zur Behandlung des Gutes sind z.B. das chemische oder elektrolytische Ätzen, Galvanisieren, Dotieren, Texturieren, Aktivieren oder Reinigen sowie die zugehörigen Spül- und Trocknungsprozesse. In den bekannten nasschemischen oder elektrolytischen Durchlaufanlagen wird das Gut mittels angetriebener Walzen und/oder mit Rädchenwellen gefördert. Durch die zunehmende Miniaturisierung der Produkte steigen die Anforderungen an das Fördersystem. Zum einen dürfen die Oberflächen des Gutes durch die Fördermittel nicht beschädigt werden und zum anderen muss Bruch empfindliches Gut sicher durch die gesamte Durchlaufanlage gefördert werden können. Das Problem des Bruches ist bei Solarzellen wegen der technologischen Entwicklung sehr groß, besonders wegen der Abnahme ihrer Dicke. Angestrebt werden Dicken der Solarzellen von 0,14 mm und darunter. Erschwerend kommt hier hinzu, dass die Fläche der zu produzierenden Solarzellen zunimmt. Aus diesem Grunde steigt die Bruchrate in den bekannten Durchlaufanlagen an, was unerwünscht ist.

### Stand der Technik und Nachteile

Die Druckschrift EP 1 354 830 B1 beschreibt für eine Durchlaufanlage Transportachsen, Transportrollen, Niederhalter und ein Fördersystem zur Behandlung von empfindlichem Gut, vorzugsweise für Solarzellen. Jeweils ein Niederhalter als Hülse an der Oberseite des horizontal ausgerichteten Gutes dient zur Förderung und zur Spurhaltung eines Gutes. Die lang gestreckte Hülse befindet sich zentrisch gelagert und beweglich auf einer angetriebenen Achse. Der Innendurchmesser der Hülse ist größer als der Außendurchmesser der Transportachse, wodurch die Beweglichkeit erreicht wird. Der Niederhalter befindet sich oberhalb der Transportbahn des Gutes. Er liegt durch sein Eigengewicht auf der Oberseite des Gutes auf. Von der zentrischen Transportachse wird die Hülse von einem stäbchenförmigen, senkrecht zur Transportachse angeordneten Mitnehmer lose mitgenommen. Der Mitnehmer greift in eine senkrecht zur Transportachse eingebrachten Bohrung der Hülse ein und nimmt sie mit. Ein erschütterungsfreies Abrollen der Hülse auf dem Gut ist damit besonders im Bereich einer Winkelstellung des Mitnehmers von 45 Grad zur Horizontalen nicht gesichert. Die Auflagekraft des Niederhalters wird allein von seinem Gewicht bestimmt. Wegen der losen Verbindung der Transportachse mit dem Niederhalter ist eine Stromübertragung, wie sie für elektrolytische Prozesse erforderlich ist, nicht möglich.

Die Druckschrift DE 198 42 974 A1 zeigt für eine elektrolytische Durchlaufanlage untere und obere angetriebene Transportwalzen mit darauf befindlichen Fördermitteln als Kontaktmittel, Scheiben und Ringe. Das Gut wird von den Transportwalzen der Durchlaufanlage gegriffen und durch die Durchlaufanlage gefördert. Dabei wird es von den Kontaktmitteln und Scheiben bzw. Ringen beidseitig, d.h. oben und unten an den Oberflächen abrollend berührt. Für Bruch empfindliches Gut ist dieses Fördersystem nahezu ungeeignet, weil unterschiedliche Auflagekräfte durch Herstellungstoleranzen und weitere nachfolgend beschriebene Gegebenheiten der Transportwalzen zu erwarten sind. Das gleiche Problem tritt bei dem Fördersystem auf, das in der Druckschrift DE 102 09 779 A1 beschrieben ist. Auf angetriebenen Transportwellen befinden sich Fördermittel als Transporträder. Die untere Transportwelle ist zusätzlich mit mindestens einem Spurelement ausgerüstet. Es dient zur seitlichen Führung des Gutes quer zur Förderrichtung. Bei nasschemischen und elektrolytischen Leiterplattenanlagen sind Leiterplatten und Leiterfolien mit einer Breite von 800 mm und mehr, quer zur Förderrichtung gemessen, zu transportieren. In diesen bekannten Anlagen erreichen die angetriebenen Transportwellen und Transportwalzen axiale Längen von bis zu 1200 mm. Oft befindet sich der Schwerpunkt dieser Wellen und Walzen nicht in der Mitte der Transportbahn und des Gutes. Dies verursacht unterschiedliche Auflagekräfte der auf dem Gut abrollenden Mittel, wodurch es mehr oder weniger aus der Transportbahn läuft. Sind beidseitig rotierende Kontakte bei elektrolytischen Verfahren auf den Transportwellen und Transportwalzen angeordnet, dann werden in sehr nachteiliger Weise durch den unsymmetrischen Schwerpunkt auch die elektrischen Ströme eines Gleichrichters über diese Kontakte unsymmetrisch. Dies kann beim Galvanisieren Fehler in der Schichtdickenverteilung quer zur Transportbahn verursachen.

Die Transportwellen und Transportwalzen nach dem Stand der Technik liegen in der Regel nur mit ihrem Eigengewicht abrollend auf dem Gut auf. Änderungen des Niveaus des Elektrolyten im Bereich vom oberen, partiell getauchten Fördermittel können durch den Auftrieb in nachteiliger Weise Änderungen der Auflagekräfte bzw. der Kontaktkräfte verursachen.

Bei der Förderung von starren, jedoch verbogenen Leiterplatten bis zu mehreren Millimetern, was in der Praxis häufig vorkommt, ändern sich die Auflagekräfte quer zur Transportbahn bei den Transportwellen und Transportwalzen nach dem Stand der Technik erheblich. Dies kann bis zum völligen Abheben insbesondere eines oder mehrerer rotierender Kontakte an der Unterseite und an der Oberseite des Gutes führen. Dies hat elektrische Überlastungen der übrigen Kontakte und gegebenenfalls Kontaktabbrand zur Folge, denn bei Leiterplattenanlagen beträgt die Stromstärke je Kontakt typisch 50 Ampere.

In sich starre und damit mechanisch stabile Transportwellen oder Transportwalzen nach dem Stand der Technik sind wegen ihrer oben beschriebenen Eigenschaften und Einsatzbedingungen nicht geeignet, Gut in mehreren Spuren nebeneinander sicher durch eine Durchlaufanlage zu fördern und elektrisch gleichmäßig zu kontaktieren. Durch die starren Wellen und durch weitere anlagentechnische Toleranzen können sich die Auflagekräfte auf dem jeweiligen Gut quer zur Förderrichtung nicht gleichmäßig verteilen. Hierdurch werden z.B. auch Partikel, die sich auf den Fördermitteln befinden können, bei örtlich größerer Auflagekraft besonders tief in die Oberfläche des Gutes eingedrückt. Dies verursacht ebenfalls Ausschuss des Gutes.

Ein weiterer Nachteil der in sich vollkommen starren und mechanisch stabilen Transportwellen und Transportwalzen wird vom Antrieb dieser Wellen verursacht. In der Regel handelt es sich um einen Zahnradantrieb, der sich an einer Seite der Transportbahn befindet. Die obere Welle liegt wegen unterschiedlich dickem, zu produzierendem Gut mit ihren Fördermitteln in der Höhenlage unbegrenzt auf der unteren in der Höhenlage fixierten Transportwelle auf deren Fördermitteln auf. Beide Wellen sind mit Zahnrädern als Stirnräder miteinander im Eingriff. Die Kraft vom unteren angetriebenen Stirnrad überträgt sich auf das obere Stirnrad. Dabei wird dieses nicht nur in Rotation versetzt, sondern es wird auch in Abhängigkeit von der Schwergängigkeit radial nach oben gedrückt. Dies hat ebenfalls eine einseitige Änderung der Auflagekraft der Transportwellen und Transportwalzen auf dem Gut zur Folge. Bei einer anderen Anordnung der treibenden Stirnräder kann die radiale Kraft des Antriebes die Transportwelle gegen das Gut drücken, was ebenfalls ungleichmäßige Auflagekräfte zur Folge hat, mit allen geschilderten Nachteilen.

Wegen der vielfältigen Nachteile der vollkommen starren und mechanisch stabilen Transportwellen und Transportwalzen nach dem Stand der Technik wäre es naheliegend, diese durch besonders elastische Wellen zu ersetzen. Hierfür könnten sich Wellen mit weichen Werkstoffen und/oder mit kleinen Querschnitten anbieten. Derartig elastische Wellen sind jedoch mechanisch sehr empfindlich zu handhaben und bereiten daher andere, nicht lösbare Probleme, wie nachfolgend dargelegt.

Die axiale Länge der Wellen kann 1 m und mehr betragen. Die Wellen müssen transportiert und in der Durchlaufanlage montiert werden. Insbesondere bei Bruch empfindlichem Gut muss die Entfernung von Bruchstücken des Gutes aus der Durchlaufanlage möglich sein. Hierzu müssten jeweils einige der elastischen Wellen demontiert werden. Gleiches gilt für Wartungs- und Reinigungsarbeiten. Erfahrungsgemäß erwartet der Anlagenbetreiber, dass dabei die zu handhabenden Baugruppen bei allen diesen genannten Aktivitäten nicht beschädigt oder verbogen werden können. Um dies sicher zu stellen, müssten die Wellen jedoch starr und stabil aufgebaut sein.

Bei elektrolytischen Prozessen muss über die Welle der Behandlungsstrom quer zur Förderrichtung übertragen werden. Zur Vermeidung eines unzulässig großen Spannungsabfalls muss je nach verwendetem Werkstoff ein Mindestquerschnitt der Welle verwendet werden. Gleiches gilt zur Vermeidung einer unzulässig großen Torsion der Welle. Dieser Mindestquerschnitt steht im Gegensatz zur Elastizität der Welle, die einen kleinen Querschnitt erfordert.

Beim Transport von Gut kommt es im Störungsfalle vor, dass dieses gegen die Transportwellen fährt und an ihnen blockiert wird. Elastische Wellen würden sich dabei verbiegen und unbrauchbar werden.

Nasschemische oder elektrolytische Prozesse erfordern bestimmte hydrodynamische Bedingungen an den zu behandelnden Oberflächen. Soll z.B. nur die Unterseite des Gutes behandelt werden, dann wird auch nur diese z.B. aus Schwallrohren mit der Behandlungsflüssigkeit angeströmt. Die Gegenkraft ist von den oberen Fördermitteln aufzubringen. Eine elastische Welle würde ungleiche Gegenkräfte mit einem Minimum in ihrer axialen Mitte haben. Das Umgekehrte tritt bei einer elastischen Welle mit darauf befindlichen Kontakträdern auf, die zu einer elektrischen Kontaktierung von Gütern dienen und die quer zur Förderrichtung transportiert werden. In der axialen Mitte wird die Kontaktkraft minimal und an den beiden Rändern der Transportbahn maximal sein.

Um die Problematik elastischer Wellen zu umgehen und trotzdem eine Ausgleichsmöglichkeit im Hinblick auf verschieden dickes Gut zu haben, ist aus dem Stand der Technik eine vertikale Verschiebbarkeit oberer Transportrollen bekannt. In der DE 102 10 538 B2 ist zum galvanotechnischen Behandeln für Behandlungsgut eine Horizontal-Durchlaufanlage gezeigt, die zum Transport des Gutes untenliegende und obenliegende Transportrollen umfasst. Zur Anpassung an unterschiedlich dickes Gut sind die oberen Transportrollen zu einer anhebbaren Baugruppe zusammengefasst. Zum Höhenausgleich der einzelnen obenliegenden Transportrollen sind diese in der Baugruppe einzeln vertikal verschiebbar gelagert. Eine ungleichmäßige Fertigung der Transportrollen sowie Schlag oder Durchbiegung derselben, von der die größte Gefährdung des zu transportierenden Gutes ausgeht, können entsprechend der Druckschrift jedoch nicht ausgeglichen werden.

Auch die US 6,045,874 offenbart zur Anpassung an verschieden dickes Gut axial beweglich gelagerte Rollen, wodurch eine ungleichmäßige Fertigung der Rollen sowie Schlag oder Durchbiegung derselben jedoch ebenfalls nicht ausgeglichen werden können. Für den angenommenen Fall einer Durchbiegung der Rollen kommt es daher zu einer ungleichmäßig pulsierenden Belastung des Gutes, woraus Oberflächenbeschädigungen oder Bruch resultieren.

Wegen des unterschiedlich dicken zu produzierenden Gutes und des damit verbundenen individuellen Ausweichens der oberen Transportwellen muss ein großes Modul der Verzahnung der Stirnräder gewählt werden, z.B. Modul 5. Diese großen Zähne an vergleichsweise im Durchmesser kleinen Stirnrädern verursachen einen unruhigen, vibrierenden Rundlauf der oberen Transportwellen und Transportwalzen. Eine elektrische Kontaktierung wird dadurch besonders an der Oberseite des Gutes unzuverlässig. Ständig wechselnde Stromverteilungen der im Eingriff befindlichen rotierenden Kontakte bis hin zur Funkenerosion mit Kontaktabbrand sind die Folge.

Durch Temperaturänderungen, die in der Praxis stets vorkommen, treten weitere Toleranzen und Fehler an den Transportwellen und Transportwalzen auf, die ebenfalls zu Qualitätsmängeln bei der Behandlung des Gutes führen können.

Aufgabe der Erfindung ist es, eine Vorrichtung und ein Verfahren zur Förderung von Gut in Durchlaufanlagen zu beschreiben, welche die genannten Nachteile des Standes der Technik nicht aufweisen. Die Erfindung soll geeignet sein, auch Gut, das an den Oberflächen empfindlich und/oder zugleich Bruch empfindlich ist, besonders in mehreren Spuren quer zur Förderrichtung bei der nasschemischen oder elektrolytischen Behandlung sicher durch die Durchlaufanlage zu transportieren. Die Erfindung soll auch die zuverlässige elektrische Kontaktierung von kleinen und sehr empfindlichen Abschnitten, wie z.B. Solarzellen aus dünnen Siliziumscheiben, ermöglichen. Ferner soll sie für den rauen nasschemischen oder elektrolytischen Betrieb sehr stabil ausgeführt sein.

Gelöst wird die Aufgabe durch die Vorrichtung nach Patentanspruch 1 und durch das Verfahren nach Patentanspruch 15. Die Unteransprüche beschreiben vorteilhafte Ausführungsbeispiele der Erfindung.

In einer nasschemischen und/oder elektrolytischen Durchlaufanlage wird das einseitig oder beidseitig zu behandelnde Gut mittels Transportwellen, Rädchenwellen und/oder Transportwalzen gefördert.

Auf diesen Wellen und Walzen befinden sich Fördermittel als rotierende Transporträder oder als Kontakt- und Transporträder. Die Erfindung sieht rotierend angetriebene Wellen als so genannte Fördermittelträger zur Aufnahme und zum Tragen der Transport- und/oder der Kontaktmittel vor. Die Fördermittelträger bestehen im Wesentlichen aus mindestens zwei Wellenstäben oder Wellenstummeln, von denen mindestens einer parallel und exzentrisch zum axialen Zentrum angeordnet ist. Mittels einer Aufnahme tragen die Wellenstäbe oder Wellenstummel die Fördermittel axial begrenzt und radial beweglich mit begrenzter Auslenkung. Exzentrisch angeordnet, setzen sie diese Fördermittel auch mitnehmend in Rotation.

Wenngleich im Folgenden die bevorzugte Ausführungsform beschrieben wird, nach der die mindestens eine Aufnahme in dem mindestens einen Fördermittel und die Wellenstäbe bzw. Wellenstummel in dem mindestens einen Fördermittelträger angeordnet sind, ist auch die erfindungsgemäß gleichwirkende Ausführungsform umfasst, nach welcher die Aufnahme(n) in dem mindestens einen Fördermittelträger und die Wellenstäbe bzw. Wellenstummel in den Fördermitteln angeordnet sind.

Gleichermaßen können der oder die Fördermittelträger unterhalb und/oder oberhalb der Transportbahn angeordnet sein.

Der Fördermittelträger kann auch mittels eines einzigen rotierenden zentralen Wellenmittenstabes gebildet werden. Auf diesem Wellenmittenstab sind die Fördermittel als rotierende Transporträder oder als Kontakt- und Transporträder begrenzt radial beweglich angebracht.

Bevorzugt besteht der Fördermittelträger aus drei oder mehr exzentrischen Wellenstäben oder Wellenstummeln, wobei die Stäbe oder Stummel vorteilhaft ein rundes Profil aufweisen. Ausführungen von Durchlaufanlagen mit oberen und unteren erfindungsgemäßen Fördermittelträgern sind ebenfalls realisierbar.

Die technische Ausführung der beweglichen Aufnahme und Lagerung jedes einzelnen Fördermittels auf den Wellenstäben erlaubt die begrenzte radiale Auslenkung desselben in Bezug zum axialen Zentrum des Fördermittelträgers, ohne dabei von erforderlichen axialen Begrenzungsmitteln auf den Wellenstäben behindert zu werden. Durch diese individuelle radiale Beweglichkeit der Fördermittel auf dem Fördermittelträger ist ein selbsttätiger Toleranz- und Fehlerausgleich jedes einzelnen Transport- und/oder Kontaktmittels, die quer zur Förderrichtung angeordnet sind, gegeben.

Die Aufnahme besteht mindestens aus zwei bevorzugt kreisrunden Öffnungen in den Fördermitteln und aus axialen Wellenstäben oder Wellenstummeln mit einem Außendurchmesser, der kleiner ist als der Innendurchmesser der Öffnungen. Die Hälfte der Differenz dieser beiden Durchmesser ergibt die Strecke der nutzbaren radialen Auslenkung. Die Mitten bzw. die Mittellinien der Öffnungen und die Mitten bzw. die Mittellinien der Wellenstäbe oder Wellenstummel befinden sich auf gleich großen Teilkreisen und darauf mit bevorzugt gleich großer Teilung. Sie sind in Anzahl und Teilung untereinander kongruent. Die Mittelpunkte der Teilkreise befinden sich im axialen Zentrum des Fördermittelträgers. Die Aufnahmen wirken zugleich als Mitnehmer für die radial beweglichen Fördermittel in Rotationsrichtung des Fördermittelträgers.

In einer weiteren Ausführung der Erfindung befindet sich eine der mindestens zwei Aufnahmen im axialen Zentrum des Fördermittelträgers. Insbesondere kann diese zentrale Aufnahme die Funktion der radialen Begrenzung übernehmen. Die weitere oder die weiteren exzentrischen Aufnahmen haben dann nur noch die Funktion eines Mitnehmers der Fördermittel.

Die Transport- und/oder Kontaktmittel, ausgeführt als Walzen, Scheiben, Spurscheiben, Rädchen, Räder, Kontakträder usw. werden kurz als Fördermittel bezeichnet, wenn es keiner besonderen Differenzierung bedarf. Sie berühren das flache Gut bevorzugt an den beiden Seiten, d.h. an der Oberseite und an der Unterseite und rollen auf dessen Oberflächen ab. Kontaktmittel sind bekannte Kontakträder aller Art, die bei elektrolytischen Prozessen zur elektrischen Stromübertragung ebenfalls auf dem Gut abrollen.

Zur sicheren Stromübertragung auf das Gut ist eine bestimmte Mindestkontaktkraft erforderlich. Diese darf jedoch nicht so groß sein, dass ein empfindliches Gut zerbricht oder an der Oberfläche beschädigt wird. Gleiches gilt für die Transportmittel. Die Auflagekraft jedes einzelnen Fördermittels auf dem Gut wird erfindungsgemäß von ihrer Schwerkraft bestimmt. Diese Kraft kann für jedes Fördermittel individuell durch eine Federkraft und/oder den Einsatz eines elastischen Werkstoffs im Freiraum der Öffnungen 12 der Fördermittel erhöht oder verringert werden, wodurch ein sehr gut angepasster und damit sanfter Transport von z.B. Bruch empfindlichem Gut realisierbar ist. Bei der Kraftverringerung wirkt die Federkraft gegen die Schwerkraft obenliegender Fördermittel. Diese entgegen der Schwerkraft gerichtete Wirkung ist im Falle von unterhalb des Gutes angeordneten Fördermitteln ebenfalls von Vorteil. Ohne die Federkraft würden diese aufgrund ihres Eigengewichtes jederzeit auf den Wellenstäben oder Wellenstummeln aufliegen. Ein erfindungsgemäßes Ausweichen vom Gut weg und somit nach unten wäre demnach trotz der unterschiedlichen Durchmesser von Wellenstäben und Öffnungen nicht möglich. Aufgrund der Kraft des Feder bzw. des elastischen Werkstoffs können die Mittellinien von jeweiligem Wellenstab und Öffnung jedoch annähernd kongruent gehalten werden, so dass ein Ausweichen weiterhin möglich ist.

Auch der sichere Transport erfordert eine Mindestauflagekraft, die ebenfalls nicht so groß sein darf, dass es zum Bruch des Gutes kommt. In beiden Fällen erlaubt die Erfindung sehr vorteilhaft die notwendige individuelle Dimensionierung der Kräfte, die in der Durchlaufanlage bei der nasschemischen und/oder elektrolytischen Behandlung auf jedes einzelne Gut wirken. Dabei ist es besonders vorteilhaft, dass sich diese Einstellungen auch langfristig nicht verändern können.

Zusammengefasst ist ein sicherer Transport bzw. eine sichere Förderung dann gegeben, wenn das Gut nicht zerbrochen und an der Oberfläche nicht beschädigt wird. Zusätzlich wird unter sicherem Transport bei elektrolytischen Prozessen eine fehlerfreie und reproduzierbare Stromübertragung auf jedes individuelle Gut verstanden.

### Figurenbeschreibung

Die Erfindung wird nachfolgend an Hand der schematischen und nicht maßstäblichen Figuren 1 bis 10 detailliert beschrieben. Die Figuren zeigen die Erfindung im Schnitt oder teilweise im Schnitt.

**Figur 1** zeigt eine erste Ausführung eines Fördermittelträgers mit Fördermitteln, die mit ihrer Schwerkraft auf dem Gut aufliegen.

**Figur 2** zeigt einen weiteren Fördermittelträger mit Fördermitteln, die mit zusätzlicher Federkraft auf dem Gut aufliegen.

**Figur 3** zeigt Fördermittelpaare, jeweils mit mindestens einem gemeinsamen, nicht gelagerten Verbindungsstück.

**Figur 4** zeigt ein Ausführungsbeispiel der Erfindung für ein Gut, das eine Breite hat, die etwa der Breite der nasschemischen oder elektrolytischen Durchlaufanlage quer zur Förderrichtung entspricht.

**Figur 5** zeigt den Fördermittelträger der Figur 1 im Querschnitt A - B mit zwei Wellenstäben und den zwei exzentrischen Aufnahmen des Fördermittels.

**Figur 6** zeigt als weiteres Ausführungsbeispiel einen Fördermittelträger im Querschnitt mit fünf Wellenstäben und den fünf exzentrischen Aufnahmen eines in der Mitte durchbrochenen Fördermittels.

**Figur 7** zeigt einen Fördermittelträger mit einem nicht rotierenden Versorgungsrohr in seinem axialen Zentrum.

**Figur 8a** zeigt einen Fördermittelträger mit nur einem rotierenden Wellenmittenstab.

**Figur 8b** zeigt desgleichen einen Fördermittelträger, wobei die Aufnahme der Fördermittel invers zur Aufnahme gemäß der Figur 8 a erfolgt.

**Figur 9** zeigt im Ausschnitt ein Fördermittel mit Bordscheiben zur Spurhaltung des Gutes, wobei die Bordscheibe und das Fördermittel eine konstruktive Einheit bilden sowie eine Transportbasis als Transportwalze.

**Figur 10** zeigt im Ausschnitt eine gesonderte Bordscheibe und ein Fördermittel, wobei als Transportbasis je ein Transportrad dient.

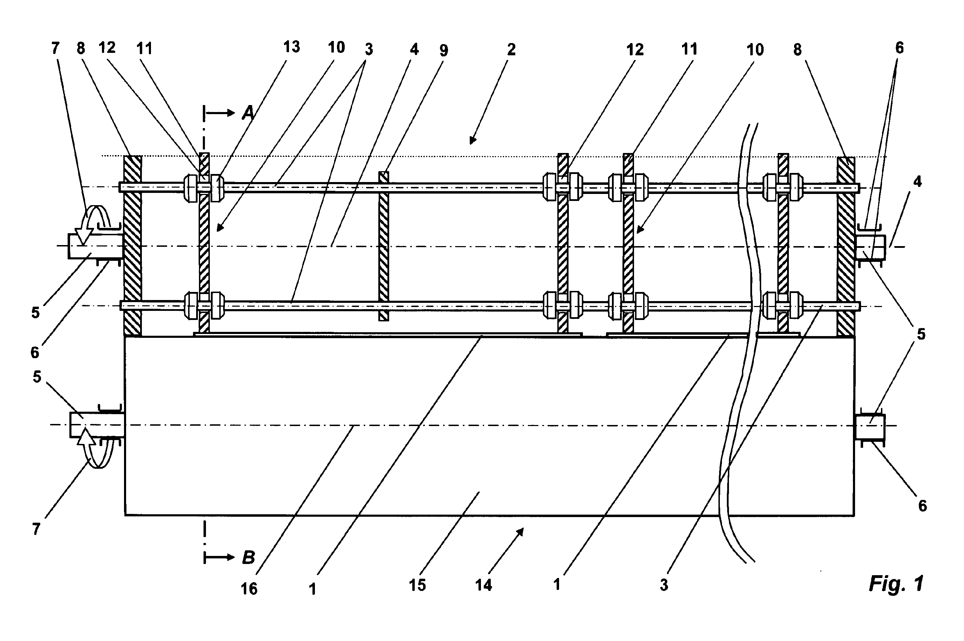

In **Figur 1** besteht der Fördermittelträger 2 aus zwei Wellenstäben 3, die parallel zum axialen Zentrum 4, d.h. zum Zentrum des Fördermittelträgers und exzentrisch zu diesem Zentrum angeordnet sind. Sie befinden sich rotationssymmetrisch zum axialen Zentrum 4 auf einem Teilkreis mit bevorzugt gleich großer Teilung für die Wellenstäbe 3. In diesem Beispiel beträgt die Teilung zweimal 180 Grad. Achsen 5 und zugehörige Lager 6 befinden sich beidseitig an der Durchlaufanlage und im Zentrum des Fördermittelträgers. Ein symbolisch mit dem Antriebspfeil 7 dargestellter Antrieb setzt den Fördermittelträger 2 und die Transportbasis 14 in Rotation. Das Gut 1 wird senkrecht in die Zeichnungsebene hinein gefördert. Die Wellenstäbe 3 sind beidseitig an kreisrunden Stirnscheiben 8 befestigt. An diesen Stirnscheiben 8 befinden sich die Achsen 5 des Fördermittelträgers 2. Zur mechanischen Stabilisierung des Fördermittelträgers 2 können sich auf den Wellenstäben 3 z.B. runde Scheiben als Stabhalter 9 befinden, die fest mit den Wellenstäben 3 verbunden sind. Ihr Außendurchmesser ist kleiner als der Außendurchmesser der Fördermittel 10. Die Wellenstäbe 3 tragen die Fördermittel 10 als Transporträder 11. Die Fördermittel 10 sind mit Aufnahmen als Öffnungen 12 versehen, die einen größeren Durchmesser aufweisen, als der Durchmesser der Wellenstäbe 3 in diesem Bereich. Die Öffnungen 12 befinden sich auf einem zur Mitte 4 rotationssymmetrischen Teilkreis. Die Fördermittel 10 sind somit lose und radial verschiebbar zum axialen Zentrum 4 angeordnet. Die halbe Differenz der Durchmesser der Öffnungen 12 und der Wellenstäbe 3 bestimmt die Weite der radialen Auslenkung der Fördermittel 10, d.h. der Transporträder 11. Die Fördermittel 10 liegen nur mit ihrem Eigengewicht auf dem Gut 1 auf und rollen bei Rotation des Fördermittelträgers 2 auf diesem, das Gut transportierend ab. Jedes der in der Regel mehreren Fördermittel eines Fördermittelträgers 2 ist unabhängig von den anderen Fördermitteln radial beweglich und weitgehend entkoppelt von Erschütterungen, denen die Wellenstäbe 3, vom Antrieb über die Lager 6 ausgehend, ausgesetzt sind. Auch Herstellungstoleranzen der Konstruktionselemente gleichen sich völlig aus. Dadurch rollen alle Fördermittel 10 eines Fördermittelträgers 2 sehr sanft mit gleicher und gleichbleibender Andruckkraft und frei von Erschütterungen auf dem Gut 1 ab. Dies ist besonders bei Bruch empfindlichem Gut, wie z.B. Wafer oder Solarzellen aus Silizium sehr vorteilhaft. Das Eigengewicht der Fördermittel 10 kann durch Veränderung ihrer Masse, durch Änderung des Volumens und/oder der Werkstoffe an den jeweiligen Bedarf angepasst werden.

Eine weitere Möglichkeit zur Anpassung bzw. Erhöhung der Auflagekraft des Fördermittels auf dem Gut besteht durch eine Auffüllung des von den Wellenstäben 3 und den Öffnungen 12 gegebenen Freiraumes mit einem elastischen Werkstoff. Das radiale und individuelle Ausweichen der Fördermittel und damit die Änderung der Auflagekraft wird dadurch ergänzend zum Eigengewicht des Fördermittels von der Elastizität des Werkstoffes bestimmt. Außerdem werden neben der Beweglichkeit der Fördermittel auch Erschütterungen, die von den Wellenstäben ausgehen können, wirksam gedämpft. Von besonderem Vorteil ist die beschriebene Verwendung eines elastischen Werkstoffs auch im Fall von unterhalb des Gutes angeordneten Fördermitteln (s.o.).

Die axiale Position der Fördermittel 10 auf den Wellenstäben 3 wird von den Abmessungen des Gutes 1 und/oder den darauf vorgegebenen Transport- oder Kontaktspuren quer zur Förderrichtung bestimmt. Zur Einhaltung dieser Positionen dienen Begrenzungsringe 13 als Stellringe auf den Wellenstäben 3. Sie weisen einen Außendurchmesser auf, der größer ist als der Durchmesser der Öffnungen 12 der Fördermittel 10. Sie sind axial so voneinander beabstandet auf den Wellenstäben angeordnet, dass die Fördermittel in ihrer radialen Beweglichkeit nicht behindert werden. Der Außendurchmesser der Fördermittel 10 entspricht dem Außendurchmesser der Stirnscheiben 8. Denselben äußeren Durchmesser weist die Transportbasis 14 an der anderen, d.h. an der unteren Seite des Gutes 1 auf. Ihre Rotationen bestimmen die Fördergeschwindigkeit des Gutes durch die Durchlaufanlage.

In Figur 1 handelt es sich bei der Transportbasis 14 um eine Transportwalze 15, die ebenfalls angetrieben ist. Diese Rotation und ihr Antrieb wird vom Antriebspfeil 7 symbolisiert. Die Laufflächen der Außendurchmesser der Stirnscheiben 8, die auf der Transportbasis 14 abrollen und die Laufflächen der Außendurchmesser der Transportwalzen 15 bestimmen den Abstand des axialen Zentrums 4 von der Basismittellinie 16. Dies stellt bei ausreichend groß dimensioniertem Gesamtgewicht der Fördermittelträger 2 sicher, dass die Fördermittel 10 mit und ohne Gut 1 radial beweglich bleiben und nicht von den Wellenstäben 3 begrenzt bzw. eingeklemmt werden. Die halbe Differenz der Durchmesser der Wellenstäbe 3 und der Öffnungen 12 wird hierzu größer gewählt, als die maximale Dicke des zu behandelnden Gutes 1. Dies stellt sicher, dass auch das dicke Gut 1 mit den gleichen erfindungsgemäßen vorteilhaften Eigenschaften gefördert werden kann, wie ein dünnes Gut. Die Öffnungen 12 sind rotationssymmetrisch mit gleicher Teilung auf einem ebensolchen Teilkreis angeordnet, wie die Wellenstäbe 3 der Fördermittelträger 2 auf den Stirnscheiben 8 angeordnet sind. Die Öffnungen 12 sind damit kongruent zu den radialen Positionen der Wellenstäbe 3. Die Fördermittel 10 können somit auf die zur Mitte 4 exzentrisch angeordneten Wellenstäbe 3 aufgesteckt und von diesen aufgenommen und getragen und mit dem Fördermittelträger 2 in Rotation versetzt werden. Wegen der Differenz der Durchmesser der Wellenstäbe 3 und der Öffnungen 12 bleibt eine in der Weite der Auslenkung begrenzte Beweglichkeit der Fördermittel stets erhalten. Durch diese Begrenzung wird sehr vorteilhaft eine Beschädigung der Fördermittel bei z.B. Störungen in der Durchlaufanlage oder beim Transport oder Handhaben außerhalb derselben durch eine zu große Auslenkung vermieden.

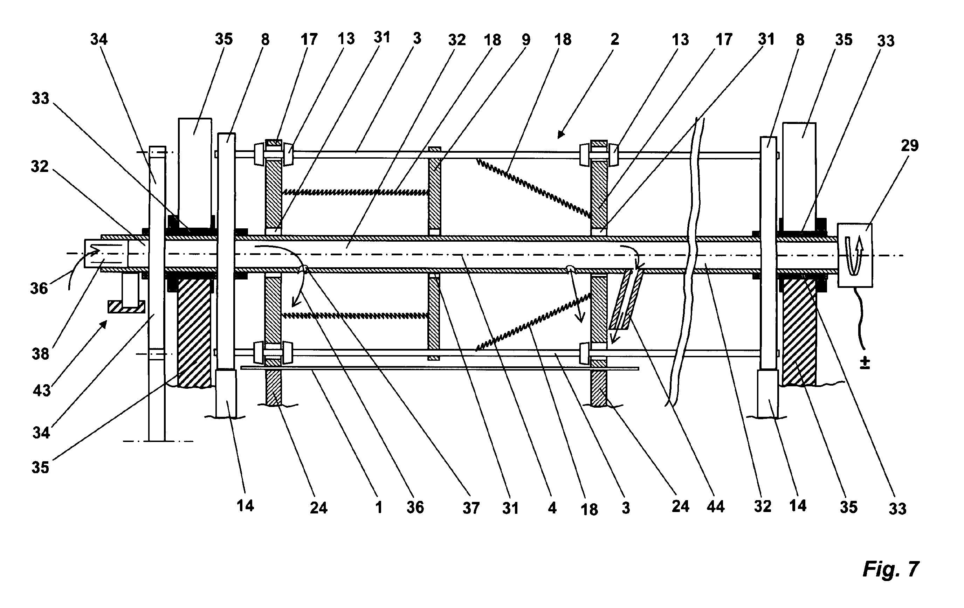

Der Außendurchmesser der Transporträder 11 bzw. der Kontakträder 17 entspricht den Außendurchmessern der gesamten diesbezüglichen Antriebselemente der Durchlaufanlage, d.h. der Transportbasis 14, der Stirnscheiben 8 und/oder des Gegenrades 24, das u. a. die Figur 7 zeigt. Dieses Gegenrad 24 kann auch als Kontaktmittel bzw. als Kontaktrad ausgeführt sein. Die Ausführung der Fördermittelträger 2 erlaubt auch die Möglichkeit der Anordnung eines weiteren Wellenstabes im Bereich des axialen Zentrums 4. Er hat bevorzugt keinen Angriffspunkt zur Mitnahme der Fördermittel 10 und trägt somit nicht zur Rotation derselben bei. Er kann jedoch den Fördermittelträger 2 zusätzlich mechanisch stabilisieren und zur axialen Positionierung der Fördermittel 10 mittels Begrenzungsringe 13 verwendet werden. Die Fördermittel 10 weisen in diesem Falle auch in ihrem Zentrum eine Öffnung bzw. einen Durchbruch auf. Dies reduziert die Anzahl der erforderlichen Begrenzungsringe 13, insbesondere dann, wenn mehr als zwei Wellenstäbe verwendet werden. Begrenzungsringe 13 sind dann nur auf diesem zentralen Wellenstab erforderlich. Bei wechselnden zu produzierenden Breiten des Gutes in der Durchlaufanlage verringert sich dadurch die Umrüstzeit der Fördermittelträger.

Wird in Ausnahmefällen nur ein exzentrischer Wellenstab 3 und ein Wellenstab im Zentrum 4 des Fördermittelträgers verwendet, dann dient auch der zentrische Wellenstab zur Aufnahme und Mitnahme der Fördermittel.

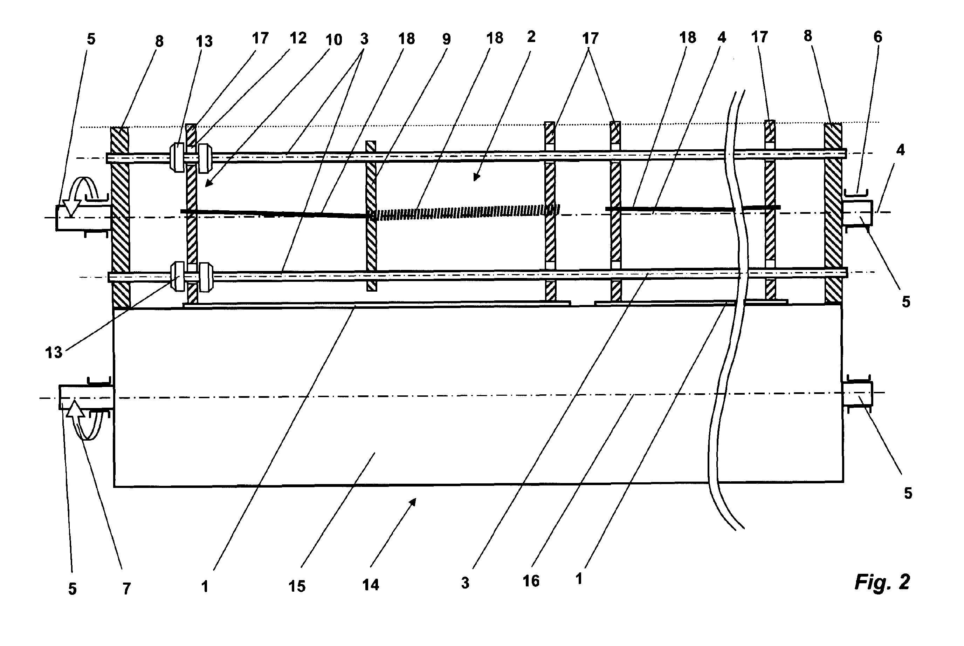

Die **Figur 2** zeigt eine weitere Ausführung des Fördermittelträgers 2. Sie kommt insbesondere dann zur Anwendung, wenn das Gut 1 elektrolytisch zu behandeln ist. Die Fördermittel 10 übernehmen neben der Funktion eines rotierenden Transportmittels zugleich die Funktion eines rotierenden Kontaktmittels als Kontaktrad 17. Dieses Kontaktrad 17 kann mindestens am Umfang einen geschlossenen Metallring oder Metallreifen zur elektrischen Stromübertragung auf das Gut 1 aufweisen. In diesem Falle handelt es sich um ein bekanntes Kontaktrad. Das Kontaktmittel kann auch als ein bekanntes segmentiertes Kontaktrad ausgeführt sein. Jedes Kontaktrad 17 wird von mindestens einem gestreckten oder gewundenen Federelement 18 als Federachse, die in dieser Figur im Zentrum des Fördermittelträgers 2 und des Kontaktrades 17 angeordnet ist, gehalten. Bei einer exzentrischen Anordnung der Federachsen werden bevorzugt mindestens zwei am Umfang des Kontaktmittels verteilte Federelemente, z.B. als gewickelte Federstäbe, wie in der Mitte der Figur 2 dargestellt oder als gestreckte Federstäbe verwendet. Damit bleibt das Zentrum des Fördermittelträgers 2 frei für andere Funktionen.

Fixpunkt der Federelemente 18 ist der Stabhalter 9, der an den Wellenstäben 3 befestigt ist oder unmittelbar die Wellenstäbe 3. Die Weite der radialen Auslenkung der Kontaktmittel wird wieder im Bereich der Aufnahmen, d.h. exzentrisch zur Mitte 4 durch die Öffnungen 12 und den dort befindlichen Wellenstäben 3 begrenzt. In Folge der Öffnungen 12 und der Federelemente 18 kann sich jedes Fördermittel 10 individuell radial bewegen und mit einer vorbestimmten Andruckkraft auf dem Gut 1 abrollen. Bei elektrolytischen Prozessen, d.h. beim Galvanisieren oder beim elektrolytischen Ätzen sind die Federelemente 18 elektrisch leitfähig. Sie dienen zugleich zur Stromübertragung von den Wellenstäben 3 über die Stabhalter 9 zu den Kontakträdern 17. Die bekannten Dreh- oder Schleifkontakte zur elektrischen Stromübertragung auf die rotierende Achse 5 und auf die Stirnscheiben 8 sind hier nicht dargestellt. Alle beteiligten Bauelemente des Fördermittelträgers 2 müssen in diesem Falle elektrisch leitfähig sein. Beim elektrolytischen Metallisieren werden die nicht direkt Kontakt gebenden Oberflächen dieser Bauelemente vorteilhaft elektrisch isoliert, um eine unerwünschte Metallisierung zu vermeiden, wenn sich diese Oberflächen im Elektrolyten befinden. Auch partiell oder völlig außerhalb des Elektrolyten ist der obere Fördermittelträger 2 verwendbar. In diesem Falle verringert sich der Bedarf an Maßnahmen zum Schutz der Oberflächen gegen eine unerwünschte Metallisierung.

Die Federelemente 18 ermöglichen ein außerordentlich gleichmäßiges und erschütterungsfreies Abrollen jedes Kontaktmittels 17 auf dem Gut 1. Des Weiteren kann ihre Andruckkraft an das Gut 1 durch Dimensionierung der Abmessungen und durch die Wahl der Werkstoffeigenschaften der Federelemente 18 sehr genau und reproduzierbar an die Erfordernisse und Eigenschaften des Gutes 1 angepasst werden. Dies ist besonders vorteilhaft beim Transport der sehr zerbrechlichen Solarzellen. Bestimmend sind bei den Abmessungen sowohl der Durchmesser der Federelemente 18 als auch ihre nicht eingespannte Länge.

Auch das Ausfüllen der Löcher 12 mit einem elastischen Werkstoff, wie es oben beschrieben wurde, erlaubt eine ergänzende Anpassung der Andruckkraft an das Gut.

Zusammengefasst wird durch eine Anpassung der Andruckkraft des Fördermittels auf das Gut mittels Vergrößerung oder Verringerung der Masse des bzw. der Fördermittel oder durch die Kraft des Federelementes das Gut sicher gefördert und elektrisch kontaktiert.

In Figur 2 sind als Federelemente 18 sehr bewegliche gewickelte Federn und Federstäbe dargestellt. Bei chemischen Prozessen oder Spülprozessen kann das Federelement 18 auch aus einem elektrisch nicht leitenden Werkstoff, z.B. aus faserverstärktem oder einem anderen elastischen Kunststoff bestehen. Die Anzahl der Fördermittel bzw. Kontaktmittel eines Fördermittelträgers 2 richtet sich nach der Anzahl der quer zur Förderrichtung zu transportierenden Güter wie z.B. Wafer, Hybride oder Solarzellen und den dafür vorgesehenen Transportspuren und/oder Förderspuren. Weil durch die gegebenen Durchmesser der Öffnungen 12 und der Wellenstäbe 3 die maximale Auslenkung der Fördermittel begrenzt wird, kann eine Beschädigung der Federelemente und der Fördermittel durch eine zu große Auslenkung bei der Handhabung zur Inbetriebnahme der Durchlaufanlage, bei der Wartung und während des Produktionsbetriebes nicht erfolgen. Dies gilt auch dann, wenn ein außerordentlich weiches Federelement verwendet werden muss, um sehr bruchempfindliches Gut 1 fördern zu können.

Die Vorspannung der Federelemente 18 kann auch durch den Außendurchmesser der Stirnscheiben 8 und den Außendurchmesser der Transportbasis 14 im Bereich der Stirnscheiben 8 eingestellt werden. Mit kleiner gewähltem Außendurchmesser der Stirnscheiben 8 gegenüber dem Außendurchmesser der anderen Fördermittel nimmt die Vorspannung und damit die Auflagekraft der Transporträder und Kontakträder auf dem Gut zu. Bei ausreichend großem Gesamtgewicht der Fördermittelträger 2 nähern sich in diesem Falle das Zentrum 4 und die Basismittellinie 16 an, wodurch sich die Vorspannung erhöht.

Zur Vermeidung einer zu großen axialen Verschiebung der Kontaktmittel beim Transport, bei der Montage oder in einem Störungsfalle mit einem Stau des Gutes in der Durchlaufanlage, können auf den Wellenstäben 3 Begrenzungsringe 13 zu beiden Seiten der Kontaktmittel angeordnet werden. In der Figur 2 sind diese nicht zwingend erforderlichen Begrenzungsringe 13 daher nur am linken Kontaktmittel dargestellt.

Auf einem Fördermittelträger befinden sich im allgemeinen mehrere Fördermittel für mehrere Spuren von Gut. Bei der elektrolytischen Behandlung des Gutes ist es wichtig, dass über alle Kontaktmittel der gleich große Behandlungsstrom fließt. Hierzu dient insbesondere die erfindungsgemäße gleich große Kontaktkraft aller Kontaktmittel. Elektrisch stellt die Stromeinspeisung eine Parallelschaltung aller Verbraucher eines Fördermittelträgers dar. Zur weiteren Verbesserung der elektrischen Stromverteilung auf das parallele Gut, das als parallele Verbraucher auf einem Fördermittelträger wirkt, können in jeden Teilstromkreis eines jeden Gutes passive und/oder aktive Mittel zur Stromverteilung auf dem Fördermittelträger eingefügt werden. Geeignet sind z.B. Vorwiderstände als so genannte Stromverteilungswiderstände. Hierzu können die Federelemente 18 sehr vorteilhaft genutzt werden. In diesem Falle wird ein Widerstandswerkstoff für die Federelemente 18 verwendet. Vorzugsweise eignen sich z.B. die resistenten Metalle Edelstahl, Titan, Niob oder Tantal. Als aktive Mittel zur Stromverteilung auf dem Fördermittelträger eignen sich z.B. elektronische Regler oder elektronische Widerstände in jedem Teilstromkreis zur individuellen Versorgung der Güter mit Behandlungsstrom. Die Anordnung der Mittel zur Stromverteilung unmittelbar auf dem rotierenden Fördermittelträger erfordert bei der passiven Lösung keinen zusätzlichen Dreh- oder Schleifkontakt. Dennoch werden z.B. 10 Teilstromkreise nahezu mit gleich großem mit Strom versorgt. Bei der aktiven Lösung ist zur Stromversorgung mindestens ein zusätzlicher Dreh- oder Schleifkontakt erforderlich. Dafür eröffnen sich weitere elektronische Steuerungs- und Regelungsmöglichkeiten direkt auf dem Fördermittelträger, insbesondere dann, wenn dieser außerhalb des Elektrolyten auf der Oberseite des Gutes abrollt.

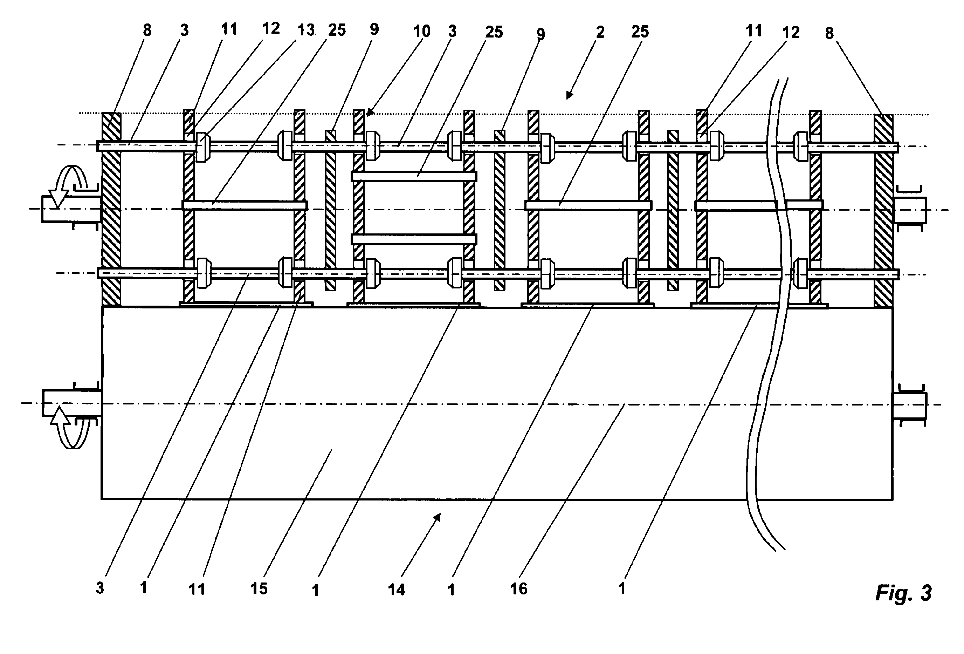

Die Wellenstäbe 3 und die Kontaktmittel 17 befinden sich in Folge der Spannungsabfälle auf den Stromverteilungswiderständen oder in der Elektronik auf unterschiedlichen elektrischen Potentialen. Daher werden diese beiden Bauelemente des Fördermittelträgers gegeneinander elektrisch isoliert, z.B. mittels eines Isolierschlauches auf den Wellenstäben. Die Stabhalter 9 können ebenfalls die Funktion von Stromverteilungswiderständen übernehmen oder zusätzlich zu den Federelementen als Widerstand wirken. Die Stabhalter 9 sind hierfür aus entsprechendem Widerstandsmaterial herzustellen. Die **Figur 3** zeigt einen Fördermittelträger 2 mit Fördermittelpaaren. Jeweils zwei Transporträder 11 sind mittels mindestens eines starren oder flexiblen Verbindungsstückes 25 mechanisch miteinander verbunden. Das Verbindungsstück 25 kann sich im Zentrum des Fördermittelträgers 2 befinden. Dieses Verbindungsstück 25 kann ebenso wie mehrere Verbindungsstücke zur Verbindung der zwei Transporträder 11 auch exzentrisch angeordnet werden. Die Aufnahme der radial beweglichen Transporträder 11 erfolgt wieder exzentrisch mittels der Wellenstäbe 3. Der axiale Abstand der beiden Fördermittel 10 eines Fördermittelpaares voneinander ist an die Breite eines Gutes 1 quer zur Förderrichtung und/oder an vorgesehene bzw. zulässige Kontakt- oder Förderspuren angepasst. Derartige Paare von Fördermitteln eignen sich besonders für die parallele Förderung von schmalem Gut durch die Durchlaufanlage. Entsprechend viele Fördermittelpaare trägt ein Fördermittelträger 2. Die Verbindungsstücke 25 können zugleich als zusätzliche Masse mit größerem Volumen zur Erhöhung der Auflagekraft ausgebildet sein.

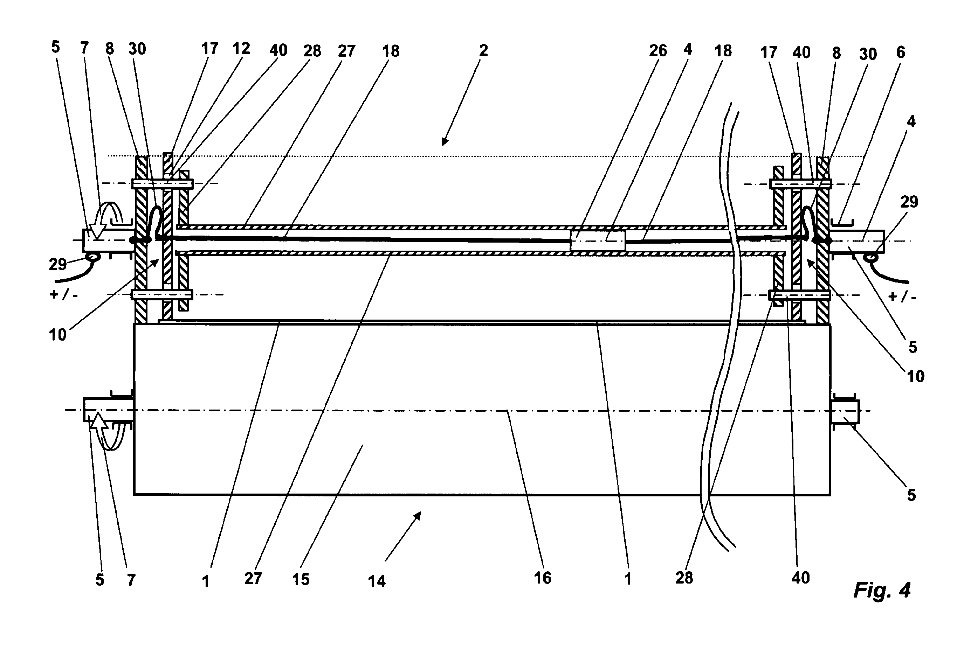

Das Ausführungsbeispiel gemäß **Figur 4** der Erfindung eignet sich besonders zur nasschemischen oder elektrolytischen Behandlung von breitem Gut 1 als Leiterplatten oder Leiterfolien. Der Fördermittelträger 2 besteht aus zwei Teilträgern an den beiden Enden und einer rohrförmigen Verbindung derselben quer über die Transportbahn. Das Gut 1 wird auch in dieser Figur 4 senkrecht in die Zeichnungsebene hinein gefördert. Der gesamte Fördermittelträger 2 und die untere Transportwalze 15 werden von dem symbolisch dargestellten Antrieb als Antriebspfeil 7 in Rotation versetzt. Die Fördermittel 10 des Fördermittelträgers 2 rollen federnd nur an den beiden Rändern auf dem breiten Gut 1 ab. Als Federelemente dienen je Seite eine Federachse 18, die z.B. in der Mitte des Fördermittelträges 2 mittels eines Mittenstückes 26 fixiert sind. Das Mittenstück 26 befindet sich in einem Achsrohr 27. Dieses Achsrohr wird von beidseitigen Flanschen 28 im axialen Zentrum des Fördermittelträgers 2 getragen. Die Flansche 28 sind mittels der Wellenstummel 40 an den Stirnscheiben 8 befestigt. Die Stirnscheiben 8 sind wieder mit den Achsen 5 verbunden. Die Außendurchmesser der Fördermittel 10 als Kontakträder 17 und der Transportbasis 14 werden bevorzugt gleich groß gewählt. Dies ergibt an der Oberseite und an der Unterseite des Gutes 1 die gleiche Umfangsgeschwindigkeit, die zugleich die Fördergeschwindigkeit des Gutes ist. Durch die Elastizität der Federachsen 18 werden die Auflagekräfte der Fördermittel 10 auf dem Gut 1 bestimmt. Die maximale Auslenkung der Fördermittel wird begrenzt durch die halbe Differenz der Durchmesser der Öffnungen 12 und der Wellenstummel 40 und/oder durch den Außendurchmesser der Stirnscheiben 8, der z.B. kleiner gewählt wird als die Außendurchmesser der Fördermittel 10 und der Transportbasis 14.

Der Fördermittelträger 2 wird so dimensioniert, dass sein Gesamtgewicht in der Behandlungsflüssigkeit größer ist als alle dagegen wirkenden Auflagekräfte der Fördermittel 10 auf dem Gut 1. Die Transportbasis 14 ist als Transportwalze 15 dargestellt. Sie kann auch als Welle mit darauf befestigten Rädchen als Gegenräder 24 ausgeführt sein. In diesem Falle befinden sich auch an den beiden Enden der Transportbasis 14 Räder, die spurgleich mit den Stirnscheiben 8 angeordnet sind. Bei Bedarf können auch auf dem Achsrohr 27 weitere Konstruktionsmittel, Rädchen und Fördermittel zum Transport des Gutes montiert werden, insbesondere dann, wenn sich auch an der Unterseite des Gutes 1 Fördermittelträger 2 befinden und/oder wenn großflächige und sehr elastische Folienabschnitte zu transportieren und zu behandeln sind. In diesem Falle können dort Führungen für das Gut, z.B. als nicht angetriebene Wälzlager angeordnet sein. Zur elektrolytischen Behandlung können im Bereich des Achsrohres 27 auch lösliche oder unlösliche Anoden bzw. Elektroden angeordnet werden.

Die Figur 4 zeigt die Fördermittelträger 2 zur elektrolytischen Behandlung des Gutes 1. Die Fördermittel 10 sind als Kontakträder 17 dargestellt. Sie sind mindestens an ihrem Umfang elektrisch leitend zur Stromübertragung auf das an der Oberfläche mindestens partiell elektrisch leitfähige Gut. Der Strom gelangt über mindestens einen Drehkontakt 29 oder Schleifkontakt auf den rotierenden Fördermittelträger 2. Ein flexibler elektrischer Leiter 30 stellt die elektrische Verbindung von der Achse 5 zum Kontaktrad 17 her. Auf den elektrischen Leiter 30 kann verzichtet werden, wenn die Stromzuführung zum Kontaktrad über das Achsrohr 27 erfolgt. Wird der Fördermittelträger 2 zur elektrolytischen Metallisierung verwendet, dann sind die elektrisch leitenden Konstruktionselemente gegen eine unerwünschte Metallisierung durch Isolation der Oberflächen zu schützen. Auch bei dieser Ausführung der Erfindung können die Federachsen 18 oder elektrischen Leiter 30 als Stromverteilungswiderstände mit verwendet werden.

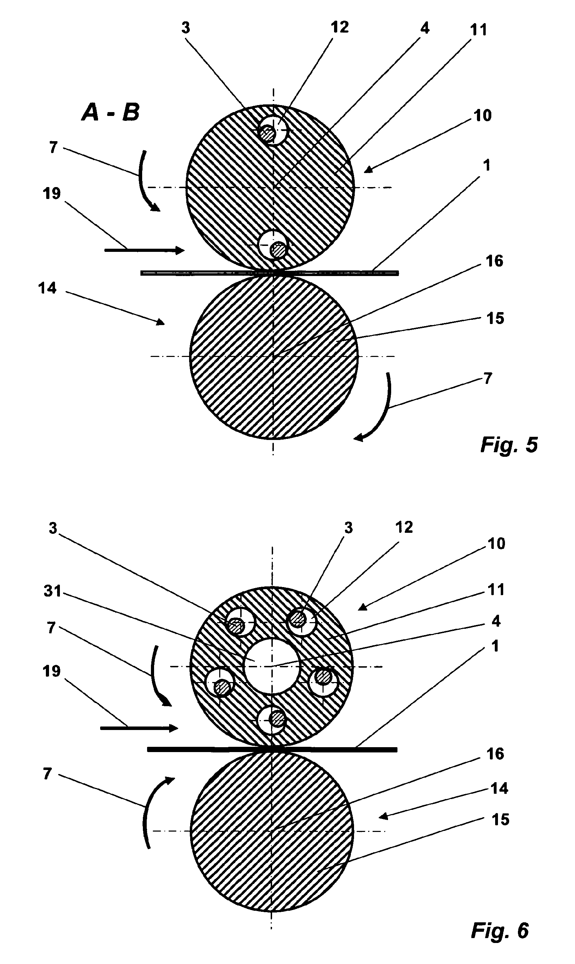

Die **Figur 5** zeigt den Fördermittelträger 2 der Figur 1 als Schnittbild A - B. Zu erkennen ist, dass das Fördermittel 10 als Transportmittel 11 von den exzentrisch eingreifenden Wellenstäben 3 im Bereich seiner Aufnahme in den Öffnungen 12 in Rotation versetzt werden kann. Dabei wird die Andruckkraft des Fördermittels 10 auf das Gut 1 nahezu ausschließlich vom Gewicht des Fördermittels 10 und einem möglichen Zusatzgewicht bestimmt. Toleranzen in den Abmessungen der Bauelemente der Fördermittelträger 2 und insbesondere des Abstandes des axialen Zentrums 4 von der Basismittellinie 16 der Transportbasis 14 sowie eine unrunde bzw. schlagende Rotation der Fördermittelträger 2 und der Transportbasis 14 haben keinen störenden Einfluss auf die sanfte und gleichmäßige Förderung jedes einzelnen Gutes 1 quer zur Förderrichtung.

Die **Figur 6** zeigt ein weiteres Beispiel eines Fördermittelträgers 2 als Schnittbild. In diesem Falle sind zur besonders gleichmäßigen Rotation der Fördermittel 10 fünf Wellenstäbe 3 auf einem rotationssymmetrischen Teilkreis mit einer gleich großen Teilung von je 72 Grad gewählt worden. Dies erhöht auch die mechanische Stabilität des Fördermittelträgers 2, insbesondere bei einer großen Länge in axialer Richtung. Im Falle eines langen Fördermittelträgers ist eine vollkommen rund laufende Rotation mit vertretbaren Kosten der Wellen und Walzen in der Praxis nahezu unmöglich zu realisieren. Derartige Toleranzen werden erfindungsgemäß ausgeglichen bei gleichzeitig besonders sanftem und erschütterungsfreiem Abrollen der Fördermittel 10 auf dem Gut 1.

Besonders lange Fördermittelträger können auch mehrere zusätzliche Stützlager, insbesondere ein Stützlager in der Mitte eines Fördermittelträgers aufweisen. Die Förderrichtung des Gutes 1 zeigt der Transportrichtungspfeil 19. Im axialen Zentrum 4 des oberen Fördermittels befindet sich in diesem Beispiel ein Durchbruch 31, der die Durchführung eines Bauelementes im Zentrum des Fördermittelträgers ermöglicht. Dieses Bauelement kann z.B. das Versorgungsrohr 32 sein, das an Hand der Figur 7 beschrieben wird. In dem Durchbruch kann ein elastischer Werkstoff angeordnet sein. Die **Figur 7** zeigt partiell einen rotierenden Fördermittelträger 2 mit einem nicht rotierenden Versorgungsrohr 32 als Achse im Zentrum 4 des Fördermittelträgers 2. Diese Achse kann zugleich als Schwallrohr für die Behandlungsflüssigkeit dienen. Auf diesem Versorgungsrohr 32 befinden sich beidseitig Lagerbuchsen 33 als Gleitlager oder Wälzlager, vorzugsweise aus Kunststoff. Die Lagerbuchsen 33 tragen mindestens die beidseitigen fest verbundenen Stirnscheiben 8 und diese den gesamten Fördermittelträger 2. Die Lagerbuchsen 33 werden in nach oben offene Langlöcher der Arbeitsbehälterwand 35 eingelegt, wodurch ein Ausweichen der Lagerbuchsen 33 zusammen mit dem Versorgungsrohr 32 nach oben möglich ist. Zur Vermeidung einer Rotation des Versorgungsrohres 32 dient ein Anschlag 43, der jedoch das Ausweichen nach oben nicht behindert. Wie dargestellt befindet sich außerhalb der Behälterwand 35 oder innerhalb ein Antriebsrad 34, z.B. als Zahnrad, das mit einer der beiden Lagerbuchsen 33 verbunden ist. Über dieses wird die Lagerbuchse 33 und damit der Fördermittelträger in Rotation versetzt, wobei das zentrale Versorgungsrohr 32 nicht rotiert.

An einem Ende des Versorgungsrohres 32 kann eine lösbare Rohrkupplung 38 zur Zuführung eines flüssigen oder gasförmigen Mediums 36 angeordnet werden. Im Versorgungsrohr 32 wird das Medium quer über die gesamte Transportbahn verteilt. Es strömt von dort aus darin befindlichen Bohrungen oder Düsen 37 in Richtung zur Oberfläche des Gutes 1 aus. Die Anordnungen und Ausführungen der Bohrungen oder Düsen 37 oder der Rohrdüsen 44 können an den Bedarf des jeweiligen Verfahrens sehr genau angepasst werden. So können z.B. auch nur die Fördermittel oder die Flächen im Bereich der Fördermittel mit einem gasförmigen oder flüssigen Medium 36 selektiv angeströmt werden, so wie es die Figur 7 zeigt. Als Medien eignen sich z.B. Spülmittel, Dosiermittel, Heißluft oder Luft. Zur Vermeidung einer Kontaminierung durch Aerosole oder einer Benetzung der Fördermittel mit Behandlungsflüssigkeit kann als Medium ein flüssiges oder gasförmiges Verdrängungsmittel verwendet werden. Dies ist insbesondere dann vorteilhaft, wenn das Gut in der Durchlaufanlage nur an der Unterseite nasschemisch oder elektrolytisch zu behandeln ist, wobei sich der Fördermittelträger an der trockenen Oberseite befindet. Durch die Integration des Versorgungsrohres 32 in den Fördermittelträger 2 können ansonsten zusätzlich erforderliche Versorgungsrohre oder Schwallrohre eingespart werden, die die Baulänge der Durchlaufanlage in nachteiliger Weise verlängern würden.

Zur elektrolytischen Behandlung des Gutes können die Fördermittel als Kontaktmittel bzw. als Kontakträder ausgeführt sein. Hierfür kann der elektrische Strom über mindestens einen Dreh- oder Schleifkontakt 29 am anderen Ende des Fördermittelträgers 2 eingespeist werden. Von dort gelangt der Strom über die elektrisch leitfähige Stirnscheibe 8, die Wellenstäbe 3 und die Stabhalter 9 zu den gestreckten oder gewundenen Federelementen 18. Vorteilhaft ist hierbei die Anordnung von zwei oder mehr Federelementen 18 je Kontaktrad.

Die Stabhalter 9 können bei langen Fördermittelträgern 2 in ihrem Zentrum an Stelle der Durchbrüche 31 auch als stützendes Wälz- oder Gleitlager ausgebildet sein.

Bei einer elektrolytischen Behandlung ist zur Erzielung einer großen Stromdichte ein intensives Anströmen der zu behandelnden Oberflächen des Gutes notwendig. Dies erfordert Schwallrohre in möglichst geringem Abstand zum Gut. Nachteilig ist dabei jedoch die Abschirmung der Anoden. Entsprechend länger müssen diese Anoden in Förderrichtung der Durchlaufanlage ausgeführt werden. Dies verlängert insgesamt die Durchlaufanlage und damit auch die Kosten derselben. Die Integration der Schwallrohre in den Fördermittelträger vermeidet diesen Nachteil.

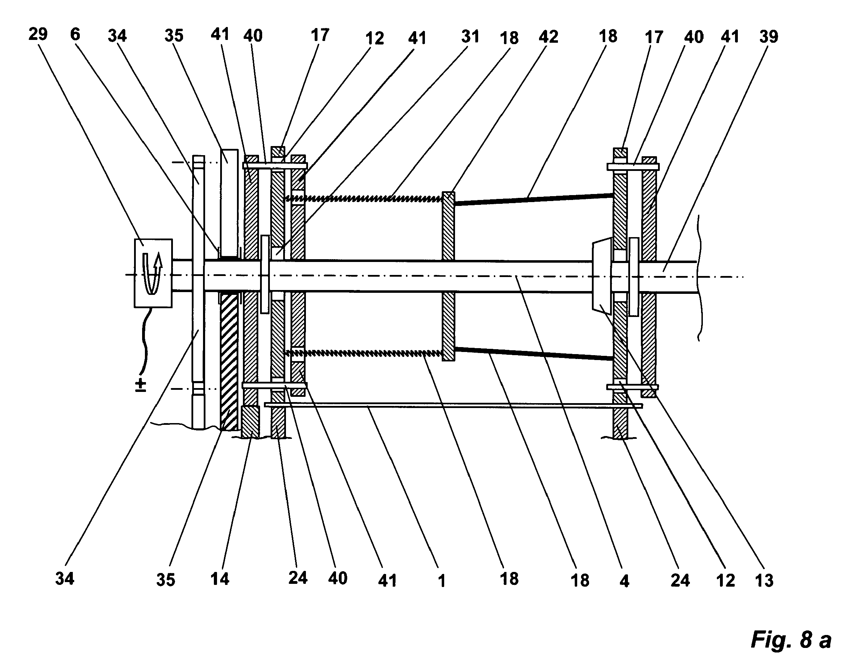

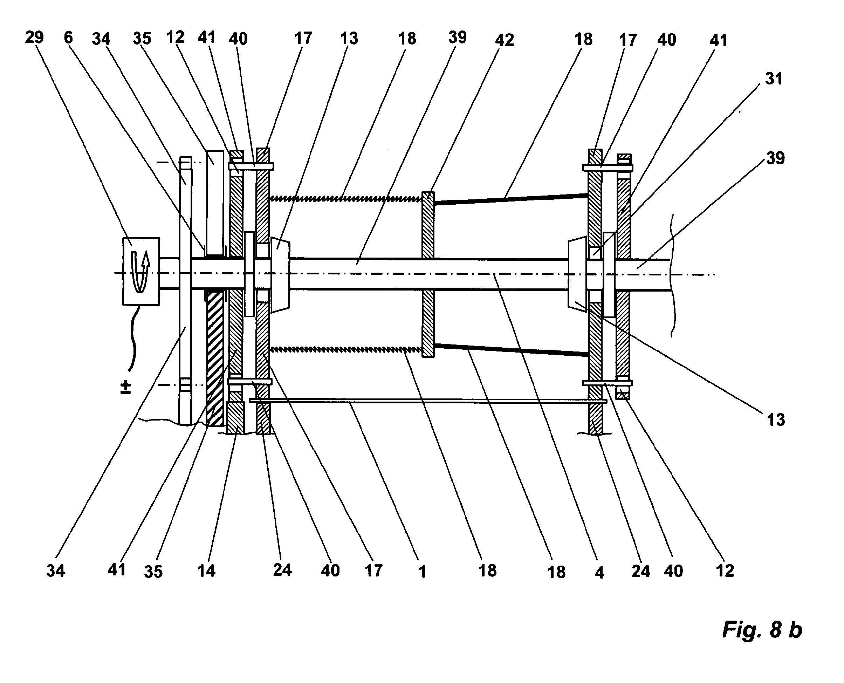

Die **Figur 8** **a** zeigt partiell einen Fördermittelträger 2 mit einem einzigen Wellenstab als Wellenmittenstab 39 im axialen Zentrum 4. Dieser erstreckt sich quer über die gesamte Transportbahn. Der zentrale Wellenmittenstab 39 trägt je Fördermittel 10 bzw. Kontaktmittel 17 mindestens einen Stummelträger 41. An Stelle der exzentrischen Wellenstäbe treten hier exzentrische Wellenstummel 40, die von den Stummelträgern 41 gehalten werden. Die Stummelträger 41 können zu beiden Seiten eines Fördermittels 10 auf dem Wellenmittenstab 39 angeordnet sein. Sie begrenzen damit die axiale Beweglichkeit des Fördermittels 10, ohne dabei die radiale Beweglichkeit zu behindern. Bei einer einseitigen Anordnung der Stummelträger 41 begrenzen Begrenzungsringe 13 auf dem zentralen Wellenmittenstab 39 oder auf den Wellenstummeln 40 die axiale Beweglichkeit, so wie es in der Figur 8 rechts dargestellt ist. Zur elektrolytischen Behandlung wird der elektrische Strom wieder über gestreckte oder gewundene Federelemente 18 dem radial beweglichen Kontaktrad 17 zugeführt. Die Federelemente 18 werden von einem Halter 42 getragen. Bei einer zweiseitigen Anordnung der Stummelträger 41 sind für die Federelemente 18 Durchbrüche mit einem ausreichend großen Durchmesser vorzusehen, damit die radiale Beweglichkeit der Kontaktmittel 17 erhalten bleibt.

Die **Figur 8b** zeigt im Vergleich zur Figur 8 a einen Fördermittelträger 2 mit einer inversen Aufnahme der Fördermittel. Die Wellenstummel 40 sind am Transportmittel 11 oder Kontaktmittel 17 fixiert. Diese Wellenstummel 40 greifen in Öffnungen 12 ein, die sich in den ursprünglichen Stummelträgern 41 befinden. Der Außendurchmesser der Wellenstummel 40 ist kleiner als der Innendurchmesser der Öffnungen 12. Dies ermöglicht ebenfalls eine begrenzte radiale Beweglichkeit der Fördermittel. Die maximale Auslenkung ist wieder von der halben Differenz der genannten Durchmesser bestimmt. Die axiale Begrenzung erfolgt durch den Begrenzungsring 13 und durch den oder die Stummelträger 41, gegebenenfalls mit Distanzscheiben, wie dargestellt.

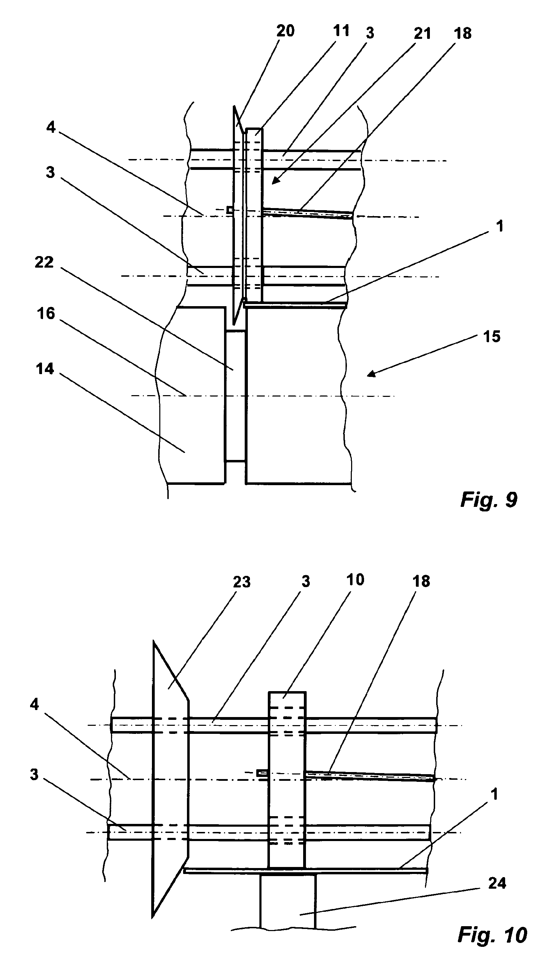

Bei längeren Durchlaufanlagen in Förderrichtung, besonders bei unterschiedlichen Prozessen und Spülprozessen besteht die Gefahr, dass insbesondere kleine zu transportierende Abschnitte wie z.B. Solarzellen oder Hybride aus der Transportbahn laufen. Deshalb sind Korrekturstationen nach bestimmten Durchlaufstrecken erforderlich. Dieser Aufwand kann durch Spurelemente oder Spurkränze an allen Fördermitteln oder in Förderrichtung an einem Teil der Fördermittel verringert werden. Die **Figur 9** zeigt eine erste Ausführung zur Spurhaltung, also zur Korrektur der Transportbahn des Gutes 1. Das kreisrunde Transportrad 11 und ein quer zur Förderrichtung angeordneter Spurkranz 20 bilden eine konstruktive Einheit als Förderspurrad 21. Der Spurkranz 20 verhindert ein aus der Spur Laufen des Gutes 1. Wenn alle Fördermittelträger mit Förderspurrädern 21 ausgerüstet werden, ist jeweils nur eine geringfügige Korrektur der Transportbahn des Gutes 1 in axialer Richtung des Fördermittelträgers 2 nötig, wodurch die Spur eingehalten wird. Der Spurkranz 20 greift mit seinem größeren äußeren Durchmesser in eine Nut 22 der Transportbasis 14 ein. Der Fördermittelträger 2 und die Transportwalze 15 werden von nicht dargestellten Antriebselementen in Rotation versetzt.

In **Figur 10** erfolgt die Spurhaltung mit getrennten Fördermitteln 10 und einem quer zur Förderrichtung angeordneten Spurrad 23. Als Transportbasis dient hier ein Gegenrad 24, das partiell dargestellt ist.

Die Erfindung beschränkt sich nicht auf die dargestellten Beispiele. Sie betrifft alle weiteren konstruktiven Lösungen wie z.B. auch beidseitig am Gut 1 angeordnete Fördermittelträger 2 mit Transportmitteln und/oder Kontaktmitteln.

### Liste der Bezugszeichen und Abkürzungen

- 1: Gut, Güter
- 2: Fördermittelträger
- 3: Wellenstäbe
- 4: axiales Zentrum des Fördermittelträgers
- 5: Achse
- 6: Lager
- 7: Antriebspfeil
- 8: Stirnscheibe
- 9: Stabhalter
- 10: Fördermittel
- 11: Transportmittel, Transportrad
- 12: Öffnung, Aufnahme
- 13: Begrenzungsring, axiale Begrenzung
- 14: Transportbasis
- 15: Transportwalze
- 16: Basismittellinie
- 17: Kontaktmittel, Kontaktrad
- 18: Federelement, Federachse
- 19: Transportrichtungspfeil, Förderrichtung
- 20: Spurkranz
- 21: Förderspurrad
- 22: Nut
- 23: Spurrad
- 24: Gegenrad
- 25: Verbindungsstück
- 26: Mittenstück
- 27: Achsrohr
- 28: Flansch
- 29: Drehkontakt, Schleifkontakt
- 30: elektrischer Leiter
- 31: Durchbruch
- 32: Versorgungsrohr
- 33: Lagerbuchse
- 34: Antriebszahnrad

- 35: Arbeitsbehälterwand
- 36: Medium
- 37: Bohrung, Düse
- 38: Rohrkupplung
- 39: Wellenmittenstab
- 40: Wellenstummel
- 41: Stummelträger
- 42: Halter
- 43: Anschlag
- 44: Rohrdüse

## Patentansprüche

1. Vorrichtung zur Behandlung von flachem Gut (1) in nasschemischen und/oder elektrolytischen Durchlaufanlagen mit quer zur Förderrichtung angeordneten unteren und oberen rotierenden Antriebselementen zur Förderung des Gutes durch die Durchlaufanlage, **gekennzeichnet durch** mindestens ein Antriebselement als Fördermittelträger (2) mit mindestens einem daran begrenzt radial beweglich aufgenommenen Fördermittel (10) als Transportmittel (11) und/oder Kontaktmittel (17), wobei sich mindestens eine Aufnahme, bestehend aus einer Öffnung (12) und einem Wellenstab (3) oder Wellenstummel (40), außerhalb des axialen Zentrums (4) befindet.

2. Vorrichtung nach Anspruch 1, **gekennzeichnet durch** Aufnahmen mit Mittellinien der Öffnungen (12), die kongruent zu den Mittellinien der Wellenstäbe (3) oder Wellenstummel (40) sind.

3. Vorrichtung nach Anspruch 1 oder 2, **gekennzeichnet durch** mindestens eine exzentrische Aufnahme und eine weitere Aufnahme im axialen Zentrum (4) des Fördermittelträgers (2).

4. Vorrichtung nach einem der Ansprüche 1 bis 3, **gekennzeichnet durch** rotierende Fördermittelträger, jeweils bestehend aus mindestens zwei Wellenstäben (3) oder Wellenstummeln (40), die auf einem Teilkreis mit bevorzugt gleich großer Teilung für die Wellenstäbe rotationssymmetrisch und parallel zum axialen Zentrum (4) des rotierenden Fördermittelträgers (2) angeordnet sind.

5. Vorrichtung nach einem der Ansprüche 1 bis 4, **gekennzeichnet durch** Fördermittel (10), die auf einem weiteren gleich großen Teilkreis rotationssymmetrisch mit bevorzugt gleich großen Teilungen Öffnungen (12) aufweisen, deren Anzahl und Mitten kongruent sind mit den axialen Mitten der Wellenstäbe (3) oder Wellenstummel (40), und deren Durchmesser größer ist als der Außendurchmesser der Wellenstäbe (3) oder Wellenstummel (40).

6. Vorrichtung nach einem der Ansprüche 1 bis 5, **gekennzeichnet durch** eine Begrenzung des in radialer Richtung beweglich aufgenommenen mindestens einen Fördermittels (10), wobei die Strecke der Auslenkung **durch** die halbe Differenz zwischen dem Durchmesser der Öffnungen (12) und dem Außendurchmesser der Wellenstäbe (3) und/oder zwischen einem Durchbruch (31) und einem Versorgungsrohr (32) oder eines Wellenmittenstabes (39) bestimmt ist.

7. Vorrichtung nach einem der Ansprüche 1 bis 6, **gekennzeichnet durch** mindestens zwei Aufnahmen der Fördermittel, wobei mindestens eine Aufnahme zugleich als Mitnehmer für das Fördermittel wirkt.

8. Vorrichtung nach einem der Ansprüche 1 bis 7, **gekennzeichnet durch** eine Auflagekraft des Fördermittels (10) auf dem Gut (1), die vom Gewicht des Fördermittels sowie gegebenenfalls **durch** eine zusätzliche Federkraft eines Federelementes (18) und/oder **durch** einen elastischen Werkstoff im Freiraum der Öffnungen (12) der Fördermittel oder im Freiraum der Öffnungen in Stummelträgern (41) oder in den Durchbrüchen (31) bestimmt wird.

9. Vorrichtung nach einem der Ansprüche 1 bis 8, **gekennzeichnet durch** mindestens ein gestrecktes oder gewundenes stabförmiges Federelement (18), das oder die mittels eines Stabhalters (9) oder Halters (42) oder der Wellenstäbe (3) am Fördermittelträger (2) zentrisch oder exzentrisch fixiert ist oder sind und das oder die am anderen Ende ein Fördermittel (10) trägt oder tragen.

10. Vorrichtung nach einem der Ansprüche 1 bis 9, **gekennzeichnet durch** elektrisch leitfähige Stirnscheiben (8), Wellenstäbe (3), Stabhalter (9), Halter (42) und Federelemente (18) zur Stromübertragung auf die Kontaktmittel (17) bei elektrolytischen Prozessen.

11. Vorrichtung nach einem der Ansprüche 1 bis 10, **gekennzeichnet durch** Fördermittelpaare, die mit mindestens einem Verbindungsstück (25) miteinander verbunden sind.

12. Vorrichtung nach einem der Ansprüche 1 bis 11, **gekennzeichnet durch** nur einen rotierenden Wellenmittenstab (39) im axialen Zentrum (4) des Fördermittelträgers (2).

13. Vorrichtung nach einem der Ansprüche 1 bis 12, **gekennzeichnet durch** die Verwendung eines nicht rotierenden Versorgungsrohres (32) im axialen Zentrum (4) des Fördermittelträgers (2) als Schwallrohr mit Bohrungen oder Düsen (37) oder Rohrdüsen (44), **durch** die Medium (36) aus dem Versorgungsrohr zum Gut oder zu den Fördermitteln strömt.

14. Vorrichtung nach einem der Ansprüche 1 bis 13, **gekennzeichnet durch** aktive und/oder passive, als Stromverteilungswiderstände wirkende Mittel auf dem Fördermittelträger (2) zur gleichmäßigen Stromverteilung auf jeden Teilstromkreis der parallel **durch** die Durchlaufanlage geförderten Güter.

15. Verfahren zur Behandlung von flachem Gut (1) in nasschemischen und/oder elektrolytischen Durchlaufanlagen mit quer zur Förderrichtung angeordneten unteren und oberen rotierenden Antriebselementen zur Förderung des Gutes durch die Durchlaufanlage, unter Verwendung einer Vorrichtung, welche mindestens ein Antriebselement als Fördermittelträger (2) mit mindestens einem daran begrenzt radial beweglich aufgenommenen Fördermittel (10) als Transportmittel (11) und/oder Kontaktmittel (17) umfasst, wobei sich mindestens eine Aufnahme, bestehend aus einer Öffnung (12) und einem Wellenstab (3) oder Wellenstummel (40), außerhalb des axialen Zentrums (4) befindet.
